# DEMANDE DE BREVET EUROPEEN

(11) **EP 1 321 430 A1**
(43) Date de publication de la demande: **25.06.2003**
(21) Numéro de dépôt: 02292916.0
(22) Date de dépôt: 25.11.2002
(51) Int. Cl.: B81B 7/00, B81B 7/02, B81C 3/00

(54) **Circuit intégré comportant un composant auxiliaire, par example un composant passif ou un microsystème électromécanique, disposé au-dessus d'une puce électronique, et procédé de fabrication correspondant**

(30) Priorité: 03.12.2001 FR 0115594
(71) Demandeur: STMicroelectronics S.A., 92120 Montrouge (FR)
(72) Inventeur: Farcy, Alexis, 73490 La Ravoire (FR); Coronel, Philippe, 38530 Barraux (FR); Ancey, Pascal, 38420 Revel (FR); Torres, Joaquin, 38950 St-Martin De Vinoux (FR)
(74) Mandataire: Casalonga, Axel

(57) **Abrégé**

La fabrication d'un circuit intégré comporte une première phase de réalisation d'une puce électronique et une deuxième phase de réalisation d'au moins un composant auxiliaire disposé au-dessus de la puce et d'un capot protecteur recouvrant le composant auxiliaire. Selon un mode de mise en oeuvre, la première phase de réalisation de la puce PC s'effectue à partir d'un premier substrat semiconducteur et comporte la formation d'une cavité CV située dans une zone choisie de la puce et débouchant au niveau de la surface supérieure de la puce. La deuxième phase de réalisation comporte la réalisation du composant auxiliaire CAX à partir d'un deuxième substrat semiconducteur SB2, distinct du premier, puis le placement dans ladite cavité, du composant auxiliaire supporté par le deuxième substrat SB2, et l'adhésion mutuelle du deuxième substrat sur la surface supérieure de la puce située à l'extérieur de ladite cavité, le deuxième substrat SB2 formant alors également ledit capot protecteur.

## Description

L'invention concerne les circuits intégrés et plus particulièrement l'incorporation de composants auxiliaires, tels que des composants passifs ou des microsystèmes électromécaniques de haute performance, sur une puce électronique.

Le développement des technologies de la microélectronique s'accompagne d'une intégration de plus en plus systématique de fonctions électriques complexes, jadis situées à l'extérieur du boîtier du circuit intégré. Parmi ces fonctions, on peut citer les microsystèmes électromécaniques (MEMS : Micro Electro Mechanical Systems) et les composants passifs connus par l'homme du métier sous la dénomination anglosaxonne de composants « above IC » (au-dessus du circuit intégré) réalisés au-dessus de la couche de passivation recouvrant le circuit intégré.

La réalisation de ces systèmes MEMS ou composants passifs requiert une stricte compatibilité, notamment thermique, de leurs étapes avec celles de la réalisation des niveaux d'interconnexion inférieurs, ainsi qu'une couche de protection avant la mise en boîtier du circuit.

Actuellement, l'incorporation des composants passifs et des microsystèmes électromécaniques de haute performance se décompose en deux étapes, à savoir l'incorporation du composant d'une part, et l'assemblage avec un capot de protection d'autre part.

La réalisation du composant a lieu directement sur la puce où sont intégrés les circuits numériques et analogiques, au-dessus d'une couche isolante de passivation.

La réalisation du capot protecteur s'effectue au moyen d'une couche supplémentaire disposée au-dessus du composant, cette couche supplémentaire devant permettre son isolation mécanique par rapport au monde extérieur sans pour autant dégrader ses performances ni empêcher ses mouvements, dans le cas notamment des microsystèmes électromécaniques. De plus, une compatibilité stricte entre l'empilement « puce-composant-capot protecteur » et les procédés standards de mise en boîtier se révèle nécessaire, en particulier pour la connexion électrique de la puce avec le boîtier. Actuellement, on connaît des procédés qui assurent l'une ou l'autre de ces fonctions.

A titre indicatif, on peut citer le procédé connu par l'homme du métier sous la dénomination «flip-chip». Ce procédé met en jeu des contacts qui assurent la tenue mécanique de l'empilement et la connexion électrique entre la puce et la face inférieure du capot. Plus précisément, une plaque, alignée par rapport à la couche de passivation sur laquelle a été réalisé le composant, est collée lors d'une fusion partielle à moyenne température à l'aide de boules de soudure qui servent alors de support. Cette procédure «flip-chip» n'endommage ni les interconnexions, ni le composant à recouvrir. Cependant, la nature discrète des boules de soudure ne permet pas de protéger les flancs du composant, par exemple un micro-commutateur.

Selon une deuxième approche, toujours après avoir réalisé le composant sur la couche de passivation recouvrant le circuit intégré, on vient recouvrir le composant avec une plaque dans laquelle on a ménagé une cavité destinée à recevoir le composant. Cette plaque est fixée sur la couche de passivation du circuit intégré à l'aide d'un matériau polymère qui joue le rôle d'adhésif. L'isolation mécanique est totale. Par contre, les deux plaques demeurent électriquement isolées, et seule une gravure localisée du capot au-dessus des plots permettra de venir contacter le circuit inférieur au moyen d'étapes supplémentaires lors de la mise en boîtier.

Ainsi, dans l'art antérieur, aucune méthode ne permet à la fois de protéger le composant et d'assurer le contact électrique indispensable pour la mise en boîtier.

A cette limitation, s'ajoutent d'autres inconvénients liés à l'approche envisagée et qui compliquent l'intégration.

En effet, la réalisation du composant s'effectue au-dessus de la puce électronique. Pour éviter toute dégradation des niveaux d'interconnexion inférieurs, cette réalisation ne doit pas mettre en jeu des températures supérieures à 450°. Or, cette contrainte interdit notamment l'usage de matériaux spécifiques, tels que certains diélectriques à très haute permittivité.

Par ailleurs, les procédés de l'art antérieur aboutissent au final à un empilement de hauteur largement supérieure à 500 microns, ce qui ne permet plus d'appliquer les procédures habituelles de mise en boîtier. Il est alors nécessaire d'amincir le capot, mais sa manipulation devient alors une opération délicate du fait de sa fragilité mécanique.

Par ailleurs, une fois l'assemblage des plaques réalisé, il devient difficile d'effectuer de nouvelles opérations technologiques en raison de la non-uniformité de l'épaisseur du polymère adhésif et des boules de soudure qui induisent une mauvaise planéité de la surface supérieure.

L'invention vise à apporter une solution à ces problèmes.

Un but de l'invention est de proposer un assemblage qui présente une surface supérieure quasiment parfaitement plane autorisant le déroulement de nouvelles étapes technologiques.

L'invention a encore pour but de rendre compatible la réalisation d'un assemblage « puce électronique/composant », avec des procédés standards de mise en boîtier.

L'invention a encore pour but d'assurer en même temps la connexion électrique du composant sur la puce et son encapsulation mécanique.

L'invention propose donc un procédé de fabrication d'un circuit intégré comportant une phase de réalisation d'une puce électronique et une phase de réalisation d'au moins un composant auxiliaire (par exemple un composant passif ou bien un composant du type MEMS) disposé au-dessus de la puce, et d'un capot protecteur recouvrant le composant auxiliaire.

Selon une caractéristique générale de l'invention, la réalisation de la puce s'effectue à partir d'un premier substrat semiconducteur, tandis que la réalisation du composant auxiliaire s'effectue à partir d'un deuxième substrat semiconducteur, distinct du premier. On fait mutuellement adhérer le deuxième substrat supportant le composant auxiliaire, sur le premier substrat semiconducteur au niveau d'une zone d'adhésion située à l'extérieur d'une cavité contenant le composant auxiliaire et s'étendant dans l'un ou l'autre des deux substrats ou dans les deux substrats, le deuxième substrat formant alors également ledit capot protecteur.

En d'autres termes, selon l'invention, on réalise indépendamment la puce sur une plaque standard semiconductrice, et le composant auxiliaire sur une autre plaque spécifique. Ainsi, les procédés mis en jeu pour le composant auxiliaire ne risquent pas de dégrader les interconnexions de la puce.

Par ailleurs, l'utilisation d'une plaque vierge en guise de support à la réalisation du composant auxiliaire autorise un vaste choix de procédés de matériau, indépendamment des contraintes associées aux interconnexions.

La cavité peut être réalisée uniquement dans la puce à partir de sa face avant, ou bien uniquement dans la plaque utilisée pour réaliser le composant auxiliaire. La cavité peut aussi être formée deux parties de cavité respectivement formées en regard l'une de l'autre dans la puce et dans la plaque.

Ainsi selon une première variante de mise en oeuvre, la phase de réalisation de la puce comporte la formation de la cavité située dans une zone choisie de la puce et débouchant au niveau de la surface supérieure de la puce, c'est-à-dire au niveau de sa face avant, et la phase de réalisation du composant auxiliaire et du capot protecteur comporte le placement dans ladite cavité, du composant auxiliaire supporté par le deuxième substrat, et l'adhésion mutuelle du deuxième substrat sur la surface supérieure de la puce située à l'extérieur de ladite cavité, le deuxième substrat formant alors également ledit capot protecteur.

Selon une deuxième variante de mise en oeuvre, la phase de réalisation du composant auxiliaire et du capot comporte la formation de la cavité dans le deuxième substrat, et la réalisation du composant auxiliaire dans ladite cavité, puis l'adhésion mutuelle du deuxième substrat sur la surface supérieure de la puce située à l'extérieur de ladite cavité, le deuxième substrat formant alors également ledit capot protecteur.

Selon une troisième variante de mise en oeuvre, la phase de réalisation de la puce comporte la formation d'une première partie de cavité située dans une zone choisie de la puce et débouchant au niveau de la surface supérieure de la puce, c'est-à-dire de sa face avant. La phase de réalisation du composant auxiliaire et du capot comporte la formation d'une deuxième partie de cavité dans le deuxième substrat, et la réalisation du composant auxiliaire dans ladite deuxième partie de cavité, puis l'adhésion mutuelle du deuxième substrat sur la surface supérieure de la puce située à l'extérieur de ladite cavité qui est alors formée par les deux parties de cavités, le deuxième substrat formant alors également ledit capot protecteur.

Selon un mode de mise en oeuvre du procédé compatible avec les trois variantes évoquées ci-dessus, la réalisation du composant auxiliaire comporte :
- la formation sur un support initial, par exemple un substrat de silicium, d'une couche intermédiaire composée d'au moins une sous-couche d'un matériau sélectivement éliminable par rapport au matériau formant le deuxième substrat et par rapport au matériau formant le support initial,
- la formation du deuxième substrat sur la couche intermédiaire, et
- la formation du composant auxiliaire sur le deuxième substrat, ce composant auxiliaire saillant de la surface supérieure du deuxième substrat ( cette surface supérieure pouvant être selon la variante mise en oeuvre, plane ou en creux pour ménager une cavité ou une partie de cavité).

Par ailleurs, la réalisation du capot protecteur comporte, après l'adhésion de la surface supérieure de la puce située à l'extérieur de ladite cavité sur la partie en regard correspondante de la surface du deuxième substrat, le retrait de ladite sous-couche et du support initial.

L'utilisation d'une couche enterrée (couche intermédiaire) permet de contrôler finement l'épaisseur de la couche qui va recouvrir la puce électronique, c'est-à-dire l'épaisseur du deuxième substrat. La gravure des vias (trous d'interconnexion) s'en trouve considérablement facilitée et l'épaisseur de l'ensemble demeure compatible avec les procédés standards de mise en boîtier. De plus, ce procédé autorise, en guise de passivation finale, un large choix de matériaux compatibles avec les performances radio-fréquence requises, si nécessaire.

Lorsque la couche intermédiaire est entièrement formée dudit matériau éliminable, elle est totalement retirée. Cependant en variante, la couche intermédiaire peut être formée d'un empilement de plusieurs sous-couches dont certaines mais pas toutes sont composées d'un matériau sélectivement éliminable par rapport au matériau formant le deuxième substrat et par rapport au matériau formant le support initial. Dans ce cas après l'étape d'adhésion, on retire toutes les sous-couches éliminables ainsi que le support initial.

Dans cette variante , il subsiste alors des sous-couches pouvant comporter du silicium par exemple, et sur lesquelles de nouveaux transistors ou autres composants actifs pourront être par exemple réalisés.

Selon un mode de mise en oeuvre de l'invention, la réalisation de la puce électronique comporte la réalisation de premiers plots de contact débouchant à la surface supérieure de la puce à l'intérieur de la zone d'adhésion. La réalisation du composant auxiliaire comporte la réalisation de deuxièmes plots de contact à l'intérieur de la zone d'adhésion (à la périphérie du composant auxiliaire). Lors de l'adhésion mutuelle, les deuxièmes plots de contact viennent en contact avec les premiers plots de contact.

Ainsi, si les premiers et deuxièmes plots de contact sont métalliques, et que l'un au moins des premiers plots de contact est relié à la puce, tandis que l'un au moins des deuxièmes plots de contact est relié au composant auxiliaire, on assure à la fois une connexion électrique et une connexion mécanique entre la puce et le composant auxiliaire.

Il est par ailleurs particulièrement avantageux que la réalisation de chaque deuxième plot de contact comporte la formation d'un orifice traversant ledit plot. Ainsi, après la mise en contact d'un deuxième plot avec un premier plot correspondant, on réalise par métallisation un rivet dans l'orifice du deuxième plot. En d'autres termes, la métallisation des vias qui traversent le capot protecteur connecte électriquement les deux plaques et améliore la résistance mécanique de l'assemblage en générant des rivets microscopiques. Ces derniers peuvent se répartir au choix du concepteur, en des points clés de la puce afin d'optimiser la tenue mécanique de l'ensemble.

Alors que différentes possibilités sont offertes pour réaliser l'étape d'adhésion entre les deux substrats, comme par exemple l'utilisation d'un matériau polymère, il est particulièrement avantageux d'effectuer cette adhésion par un collage moléculaire à basse température. Ceci permet de ne dégrader aucun circuit. Par ailleurs, le collage moléculaire préserve la possibilité d'effectuer à la fois la connexion électrique et la connexion mécanique, alors que si une technique d'adhésion utilisant un matériau polymère entre les plots de contact, est employée, il convient de prévoir une connexion électrique en un autre endroit qu'au niveau des plots de contact.

L'invention a également pour objet un circuit intégré, comportant une puce électronique, au moins un composant auxiliaire disposé au-dessus de la puce et un capot protecteur recouvrant le composant auxiliaire.

Selon une caractéristique générale de l'invention, le composant auxiliaire saille sur la face inférieure d'un substrat semiconducteur et s'étend dans une cavité ménagée dans la puce ou dans le substrat semiconducteur ou dans les deux. Ledit substrat forme également ledit capot protecteur. La face inférieure du substrat est fixée sur la partie de la surface supérieure de la puce située à l'extérieur de ladite cavité, et la face supérieure du substrat supportant le composant auxiliaire est sensiblement plane.

Selon une première variante, la surface inférieure du substrat semiconducteur est plane, et la surface supérieure de la puce a une forme ménageant la cavité dans une zone choisie de la puce.

Selon une deuxième variante, la surface supérieure de la puce est plane, et la surface inférieure du substrat semiconducteur a une forme ménageant la cavité dans ce substrat semiconducteur.

Selon une troisième varaiante, la surface inférieure du substrat semiconducteur a une forme ménageant une première partie de cavité dans ce substrat semiconducteur, et la surface supérieure de la puce a une forme ménageant une deuxième partie de cavité dans une zone choisie de la puce. Ladite cavité est alors formée des deux parties de cavité en regard l'une de l'autre.

Selon un mode de réalisation de l'invention compatible avec ces trois variantes, la puce électronique comporte des premiers plots de contact débouchant à la surface supérieure de la puce à l'extérieur de la cavité. Le composant auxiliaire comportant quant à lui des deuxièmes contacts situés à la périphérie du composant auxiliaire. Les deuxièmes plots de contact sont en contact avec les premiers plots de contact.

Le circuit intégré comporte avantageusement des rivets solidarisant chaque deuxième plot de contact avec le premier plot correspondant.

D'autres avantages et caractéristiques de l'invention apparaîtront à l'examen de la description détaillée de modes de réalisation et de mise en oeuvre, nullement limitatifs, et des dessins annexés, sur lesquels :
- la figure 1 illustre d'une façon très générale et très schématique une première mise en oeuvre du procédé selon l'invention, permettant d'aboutir à un premier mode de réalisation d'un circuit intégré selon l'invention ;
- les figures 2a et 2b illustrent plus en détail mais toujours schématiquement certaines étapes d'une mise en oeuvre du procédé, conduisant à un aménagement de la puce électronique ;
- les figures 3a à 3c illustrent plus en détail mais toujours schématiquement certaines étapes d'une mise en oeuvre du procédé aboutissant à une réalisation d'un composant auxiliaire ;
- les figures 4 et 5 illustrent plus en détail mais toujours schématiquement des étapes d'assemblage du procédé selon l'invention, permettant d'aboutir à un circuit intégré selon l'invention, et,
- les figures 6 et 7. illustrent d'une façon très générale et très schématique deux autres mises en oeuvre du procédé selon l'invention, permettant d'aboutir à deux autres modes de réalisation d'un circuit intégré selon l'invention

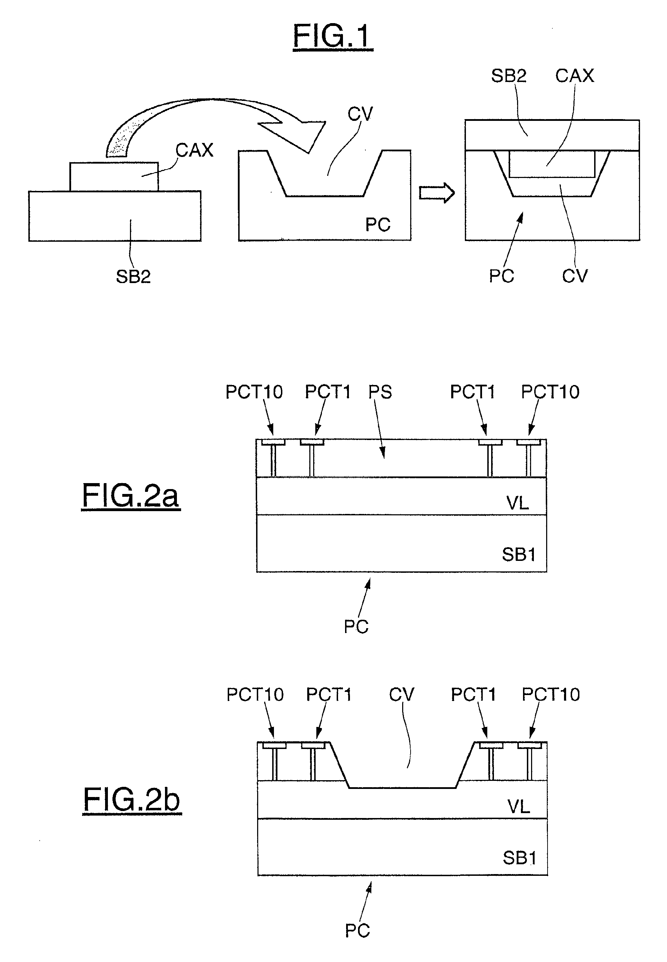

Sur la partie gauche de la figure 1, la référence SB2 désigne un substrat semiconducteur sur lequel on a réalisé un composant auxiliaire CAX, par exemple un composant passif, ou bien un microsystème électromécanique.

Par ailleurs, sur un substrat distinct du substrat SB2, on réalise de façon classique et connue en soi une puce électronique PC et l'on ménage dans la partie supérieure de cette puce électronique PC, en un endroit choisi, une cavité CV destinée à recevoir le composant CAX.

Puis, comme illustré sur la partie droite de la figure 1, on solidarise la face supérieure (devenue face inférieure sur la partie droite de la figure 1) du substrat SB2 avec la partie de la face supérieure (face avant) de la puce électronique située à l'extérieur de la cavité CV.

On obtient alors un circuit intégré qui, avant mise en boîtier, comporte un assemblage d'une puce électronique PC et d'un composant auxiliaire CAX, et dont la surface supérieure est sensiblement plane.

Ce mode de mise en oeuvre de l'invention va maintenant être explicité plus en détail, en référence aux figures suivantes.

Sur la figure 2a, la puce électronique PC est réalisée de façon classique et connue en soi à partir d'un substrat de silicium SB1, au-dessus duquel sont ménagés un certain nombre de niveaux d'interconnexion VL. L'ensemble est recouvert d'une couche isolante de passivation PS, par exemple formée de dioxyde de silicium. Des plots de contact et des pistes métalliques, PCT1, PCT10, réalisés de façon classique et connue en soi, débouchent à la surface de la couche de passivation et permettent des interconnexions avec des composants de la puce électronique située dans le substrat de silicium, par l'intermédiaire de différents niveaux d'interconnexion.

On ménage par ailleurs dans une zone choisie de la puce électronique, une cavité CV qui va être destinée à recevoir le composant auxiliaire CAX. Cette cavité CV (figure 2b) se situe dans une zone qui est par exemple dénuée de métal, et qui, de toutes façons, ne va pas conduire à interférer avec la structure ou le fonctionnement des composants électroniques de la puce. La profondeur de la cavité dépend de la hauteur du composant auxiliaire CAX qui va y être inséré. Selon les applications, elle peut ne s'étendre que dans la couche de passivation, ou bien être gravée à travers la couche de passivation, un certain nombre de niveaux d'interconnexion VL et éventuellement jusque dans le substrat SB1.

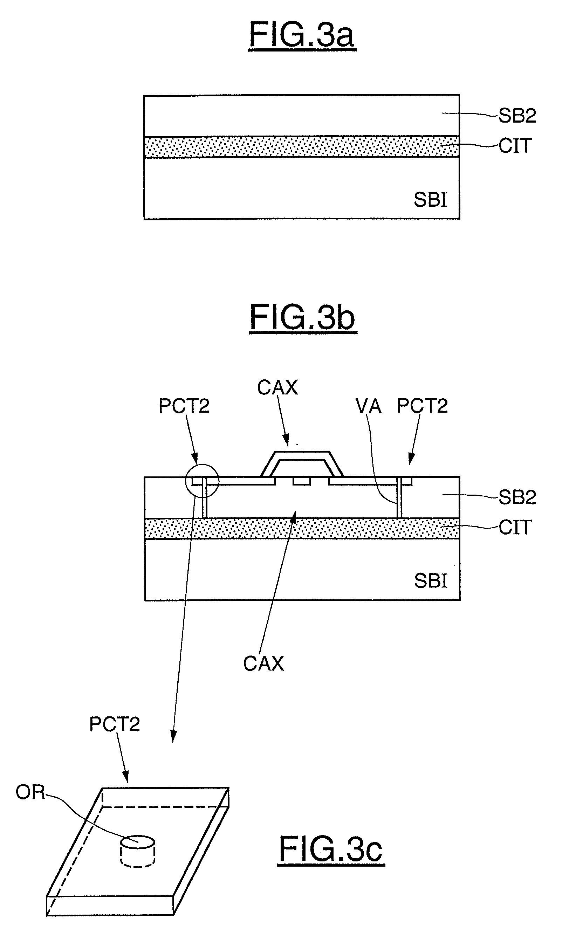

Par ailleurs, le composant auxiliaire CAX va être réalisé sur un deuxième substrat SB2 (figure 3a) qui est totalement distinct du substrat de la puce électronique PC.

Plus précisément, dans ce mode de mise en oeuvre, le substrat SB2, par exemple en silicium, est réalisé à partir d'un substrat initial SBI, sur lequel on a réalisé une couche dite « couche intermédiaire CIT ». Le substrat SB2 repose sur cette couche intermédiaire CIT.

La couche intermédiaire CIT est donc une couche enterrée. Elle est formée d'un matériau qui est sélectivement éliminable par rapport au matériau formant le substrat SB2 et le substrat SBI.

A titre d'exemple, l'ensemble formé du substrat initial SBI, de la couche enterrée CIT et du deuxième substrat SB2, peut être un substrat sur isolant (substrat SOI : « Silicon On Insulator » en langue anglaise) dont la structure et la réalisation sont bien connues de l'homme du métier. Dans ce cas, le substrat SB2 est par exemple une mince couche de silicium reposant sur du dioxyde de silicium formant la couche enterrée CIT.

En variante, la couche CIT peut être formée par une épitaxie d'un alliage de silicium-germanium sur le substrat initial SBI formé de silicium. Puis, le deuxième substrat SB2 en silicium est lui-même épitaxié sur la couche CIT.

Puis, comme illustré sur la figure 3b, on réalise dans et sur le substrat SB2, de façon classique et connue en soi, un composant auxiliaire CAX, ici un microsystème électromécanique.

Ce composant CAX comporte des extensions périphériques formant des plots de contact PCT2.

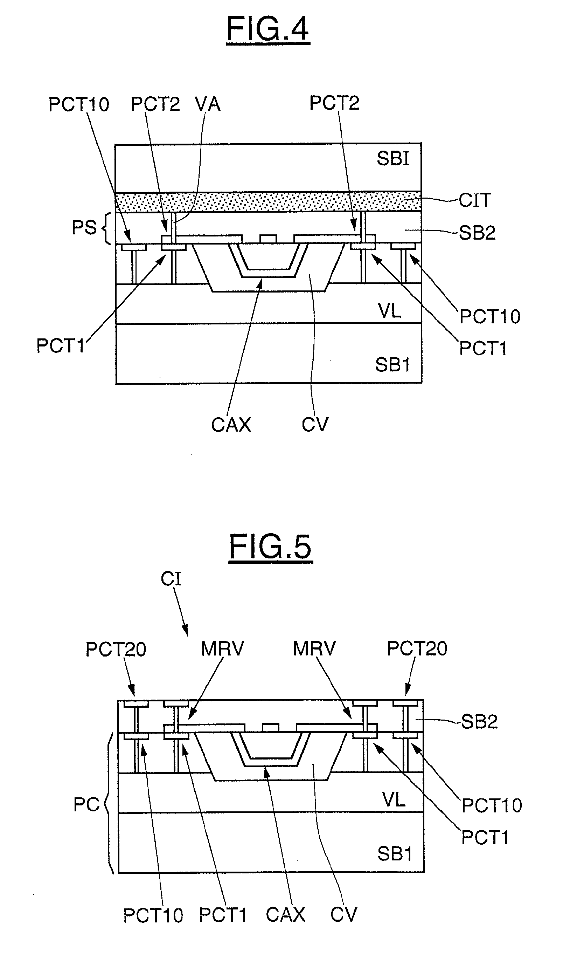

Comme illustré sur la figure 3c, chaque plot de contact PCT2 est percé d'un orifice central OR qui se prolonge par un trou ou via VA dans le substrat SB2 jusqu'à la couche enterrée CIT. Néanmoins en variante, cet orifice central peut être gravé ultérieurement, par exemple en même temps que les cavités PCT20 (figure 5), une fois l'adhésion effectuée.

Comme on le verra plus en détail ci-après, les plots PCT2 qui encadrent le microcommutateur sont destinés à le connecter électriquement et mécaniquement à l'autre plaque, c'est-à-dire à la puce électronique, sur laquelle se trouvent les circuits de commande.

L'étape suivante consiste à retourner l'ensemble supportant le composant auxiliaire CAX, puis à aligner cet ensemble avec la puce électronique, de façon à ce que le microcommutateur CAX vienne s'emboîter parfaitement dans la cavité CV prévue à cet effet (figure 4).

Les plots de contact PCT2 viennent alors en contact avec les plots de contact PCT1 de la puce électronique.

L'adhésion du substrat SB2 sur la surface supérieure de la puce électronique située à l'extérieur de la cavité CV s'effectue de préférence par un collage moléculaire à basse température. Un tel collage moléculaire est bien connu de l'homme du métier et celui-ci pourra se référer par exemple à l'article de M. Bruel, B. Aspar, A. J. Auberton-Hervé, « Smart-Cut : a New Silicon On Insulator Material Technology Based on Hydrogen Implantation and Wafer Bonding", Japanese Journal of Applied Physics, Vol. 36, pp. 1636-1641, Part I, No. 3B, March 1997.

Ce collage moléculaire présente l'avantage de ne nécessiter aucun matériau supplémentaire pour effectuer l'adhésion. Par ailleurs, il ne dégrade aucun circuit et rend ainsi compatible une connexion électrique simultanée à une connexion mécanique effectuée au niveau des plots de contact PCT1 et PCT2.

Puis, le matériau de la couche enterrée CIT est sélectivement retiré, par exemple par une gravure sélective bien connue de l'homme du métier, dont les caractéristiques dépendent du matériau utilisé. Le retrait de ce matériau de la couche CIT entraîne également le retrait du substrat initial SBI, si celui-ci n'a pas été retiré au préalable par une autre technique, par exemple par un procédé bien connu de l'homme du métier sous la dénomination anglo-saxonne « smart-cut ».

Il ne reste alors (figure 5) que le deuxième substrat SB2 qui supporte le composant CAX et qui forme de ce fait la couche supérieure du circuit intégré formé de l'ensemble « puce électronique PC et composant auxiliaire CAX ».

On procède ensuite à une gravure du substrat SB2, de façon à réaliser des vias et des plots de contact et/ou pistes métalliques PCT20, qui vont venir contacter, après métallisation, les plots de contact et/ou pistes PCT10. De même, on réalise des cavités superficielles dans le prolongement des vias VA, qui après métallisation, vont former en surface des plots de contact et/ou des pistes métalliques. Par ailleurs, au niveau de l'interface entre le substrat SB2 et la couche de passivation de la puce électronique, cette métallisation des orifices OR va générer des microrivets MRV qui vont améliorer la tenue mécanique de l'ensemble.

Le circuit intégré ainsi obtenu présente une surface supérieure quasiment parfaitement plane et l'on pourra si nécessaire réaliser à partir de cette surface supérieure d'autres niveaux de vias et de pistes métalliques, ou de composants actifs, en particulier lorsque la couche intermédiaire était formée d'un empilement de sous-couches dont certaines n'étaient pas éliminables sélectivement. En effet, dans ce cas il subsiste sur la surface supérieure du substrat SB2, une ou plusieurs sous-couches planes, à partir desquelles on peut réaliser ces autres niveaux.

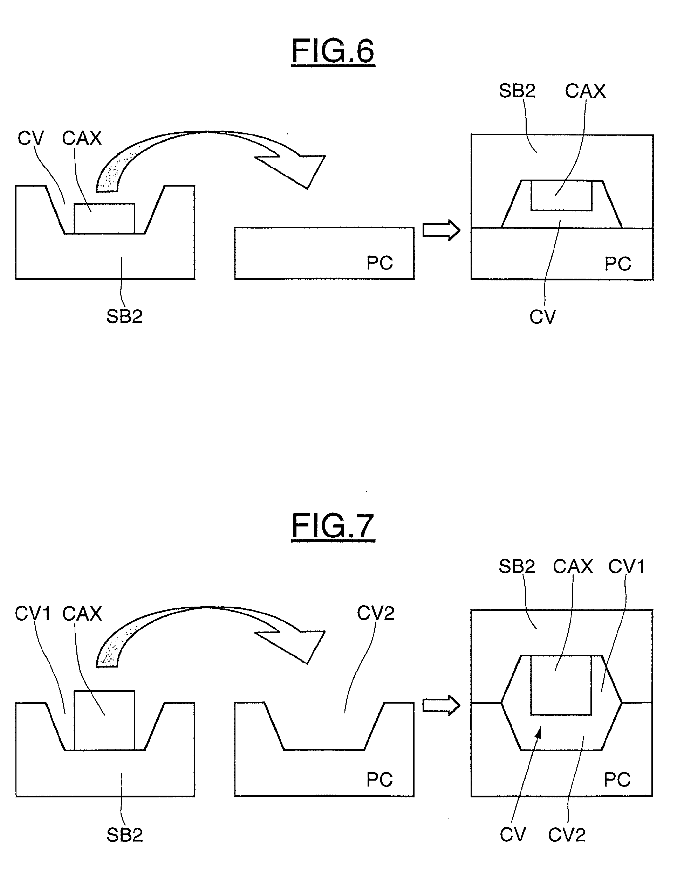

Alors que dans la variante qui vient d'être décrite, la cavité CV a été réalisée uniquement dans le substrat SB2, il est possible de réaliser cette cavité dans la puce PC uniquement (figure 6), ou bien à la fois dans le substrat SB2 et dans la puce PC (figure 7). La cavité CV est alors composée de deux parties de cavité CV1 et CV2, en regard l'une de l'autre.

## Revendications

1. Procédé de fabrication d'un circuit intégré comportant une réalisation d'une puce électronique et une réalisation d'au moins un composant auxiliaire disposé au-dessus de la puce et d'un capot protecteur recouvrant le composant auxiliaire, **caractérisé par le fait que** la réalisation de la puce (PC) s'effectue à partir d'un premier substrat semiconducteur, **par le fait que** la réalisation du composant auxiliaire (CAX) s'effectue à partir d'un deuxième substrat semiconducteur (SB2), distinct du premier, **par le fait qu'**on fait mutuellement adhérer le deuxième substrat supportant le composant auxiliaire, sur le premier substrat semiconducteur au niveau d'une zone d'adhésion située à l'extérieur d'une cavité contenant le composant auxiliaire et s'étendant dans l'un ou l'autre des deux substrats ou dans les deux substrats, le deuxième substrat (SB2) formant alors également ledit capot protecteur.

2. Procédé selon la revendication 1, **caractérisé par le fait que** la phase de réalisation de la puce (PC) comporte la formation de la cavité (CV) située dans une zone choisie de la puce et débouchant au niveau de la surface supérieure de la puce, et **par le fait que** la phase de réalisation du composant auxiliaire et du capot protecteur comporte le placement dans ladite cavité, du composant auxiliaire supporté par le deuxième substrat (SB2), et l'adhésion mutuelle du deuxième substrat sur la surface supérieure de la puce située à l'extérieur de ladite cavité, le deuxième substrat (SB2) formant alors également ledit capot protecteur.

3. Procédé selon la revendication 1, **caractérisé par le fait que** la phase de réalisation du composant auxiliaire et du capot comporte la formation de la cavité dans le deuxième substrat (SB2), et la réalisation du composant auxiliaire dans ladite cavité (CV), puis l'adhésion mutuelle du deuxième substrat sur la surface supérieure de la puce située à l'extérieur de ladite cavité, le deuxième substrat (SB2) formant alors également ledit capot protecteur.

4. Procédé selon la revendication 1, **caractérisé par le fait que** la phase de réalisation de la puce (PC) comporte la formation d'une première partie de cavité (CV1) située dans une zone choisie de la puce et débouchant au niveau de la surface supérieure de la puce, **par le fait que** la phase de réalisation du composant auxiliaire et du capot comporte la formation d'une deuxième partie de cavité (CV2) dans le deuxième substrat (SB2), et la réalisation du composant auxiliaire dans ladite deuxième partie de cavité (CV2), puis l'adhésion mutuelle du deuxième substrat sur la surface supérieure de la puce située à l'extérieur de ladite cavité (CV) formée par les deux parties de cavités, le deuxième substrat (SB2) formant alors également ledit capot protecteur.

5. Procédé selon l'une des revendications précédentes, **caractérisé par le fait que** la réalisation du composant auxiliaire (CAX) comporte la formation sur un support initial (SBI) d'une couche intermédiaire (CIT) composée d'au moins une sous-couche d'un matériau sélectivement éliminable par rapport au matériau formant le deuxième substrat (SB2) et par rapport au matériau formant le support initial, la formation du deuxième substrat (SB2) sur la couche intermédiaire (CIT), et la formation du composant auxiliaire (CAX) sur le deuxième substrat, ce composant auxiliaire saillant de la surface supérieure du deuxième substrat, et **par le fait que** la réalisation du capot protecteur comporte, après l'adhésion de la surface supérieure de la puce située à l'extérieur de ladite cavité sur la partie en regard correspondante de la surface du deuxième substrat (SB2), le retrait de ladite sous-couche et du support initial (SBI).

6. Procédé selon la revendication 5, **caractérisé par le fait que** la couche intermédiaire est formée d'un empilement de plusieurs sous-couches dont certaines mais pas toutes sont composées d'un matériau sélectivement éliminable par rapport au matériau formant le deuxième substrat (SB2) et par rapport au matériau formant le support initial (SBI), et **par le fait qu'**après l'étape d'adhésion, on retire toutes les sous-couches éliminables ainsi que le support initial.

7. Procédé selon l'une des revendications précédentes, **caractérisé par le fait que** la réalisation de la puce électronique (PC) comporte la réalisation de premiers plots de contact (PCT1) débouchant à la surface supérieure de la puce à l'intérieur de la zone d'adhésion, **par le fait que** la réalisation du composant auxiliaire comporte la réalisation de deuxième plots de contact (PCT2) à l'intérieur de la zone d'adhésion, **par le fait que** lors de l'adhésion mutuelle, les deuxièmes plots de contact viennent en contact avec les premiers plots de contact.

8. Procédé selon la revendication 7, **caractérisé par le fait que** la réalisation de chaque deuxième plot de contact comporte la formation d'un orifice (OR) traversant ledit plot, et **par le fait qu'**après la mise en contact d'un deuxième plot avec un premier plot correspondant, on réalise un rivet (MRV) dans l'orifice du deuxième plot.

9. Procédé selon la revendication 7 ou 8, **caractérisé par le fait que** les premiers et deuxièmes plots de contact sont métalliques, l'un au moins des premiers plots de contact (PCT1) étant relié à la puce tandis que l'un au moins des deuxièmes plots de contact (PCT2) est relié au composant auxiliaire, de façon à assurer une connexion électrique entre la puce et le composant auxiliaire.

10. Procédé selon la revendication 9, **caractérisé par le fait que** la formation de l'orifice traversant d'un deuxième plot de contact comporte le percement du deuxième plot de contact ainsi qu'une gravure du deuxième substrat (SB2) dans le prolongement du perçage du deuxième plot de contact, et **par le fait que** la réalisation du rivet comporte une métallisation de l'orifice gravé (VA) du deuxième substrat et de l'orifice traversant (OR) du deuxième plot de connexion.

11. Procédé selon l'une des revendications précédentes, **caractérisé par le fait que** l'étape d'adhésion s'effectue par collage moléculaire.

12. Circuit intégré, comportant une puce électronique, au moins un composant auxiliaire (CAX) disposé au-dessus de la puce (PC) et un capot protecteur recouvrant le composant auxiliaire, **caractérisé par le fait que** le composant auxiliaire (CAX) saille sur la face inférieure d'un substrat semiconducteur (SB2) et s'étend dans une cavité (CV) ménagée dans la puce ou dans le substrat semiconducteur (SB2) ou dans les deux, **par le fait que** ledit substrat (SB2) forme également ledit capot protecteur, **par le fait que** la face inférieure du substrat (SB2) est fixée sur la partie de la surface supérieure de la puce (PC) située à l'extérieur de ladite cavité, et **par le fait que** la face supérieure du substrat (SB2) supportant le composant auxiliaire est sensiblement plane.

13. Circuit intégré selon la revendication 12, **caractérisé par le fait que** la surface inférieure du substrat semiconducteur (SB2) est plane, et **par le fait que** la surface supérieure de la puce a une forme ménageant la cavité dans une zone choisie de la puce.

14. Circuit intégré selon la revendication 12, **caractérisé par le fait que** la surface supérieure de la puce (PC) est plane, et **par le fait que** la surface inférieure du substrat semiconducteur (SB2) a une forme ménageant la cavité dans ce substrat semiconducteur (SB2).

15. Circuit intégré selon la revendication 12, **caractérisé par le fait que** la surface inférieure du substrat semiconducteur (SB2) a une forme ménageant une première partie de cavité (CV1) dans ce substrat semiconducteur (SB2), **par le fait que** la surface supérieure de la puce a une forme ménageant une deuxième partie de cavité (CV2) dans une zone choisie de la puce, et **par le fait que** ladite cavité est formée des deux parties de cavité en regard l'une de l'autre.

16. Circuit intégré selon l'une des revendications 12 à 15, **caractérisé par le fait que** la puce électronique comporte des premiers plots de contact (PCT1) débouchant à la surface supérieure de la puce à l'extérieur de la cavité, **par le fait que** le composant auxiliaire comporte des deuxièmes plots de contact (PCT2) situés à la périphérie du composant auxiliaire, **par le fait que** les deuxièmes plots de contact sont en contact avec les premiers plots de contact.

17. Circuit intégré selon la revendication 16, **caractérisé par le fait qu'**il comporte des rivets (MRV) solidarisant chaque deuxième plot de contact avec le premier plot correspondant.

18. Circuit intégré selon la revendication 16 ou 17, **caractérisé par le fait que** les premiers et deuxièmes plots de contact sont métalliques, l'un au moins des premiers plots de contact (PCT1) étant relié à la puce tandis que l'un au moins des deuxièmes plots de contact (PCT2) est relié au composant auxiliaire, de façon à assurer une connexion électrique entre la puce et le composant auxiliaire.

19. Circuit intégré selon l'une des revendications 12 à 17, **caractérisé par le fait qu'**il comporte en outre au moins une sous-couche plane située sur la surface supérieure du substrat semiconducteur (SB2).
